# EUROPEAN PATENT APPLICATION

(11) **EP 2 602 860 A1**
(43) Date of publication of application: **12.06.2013**
(21) Application number: 11814249.6
(22) Date of filing: 19.07.2011
(51) Int. Cl.: H01M 14/00, H01L 31/04

(54) **SEALING STRUCTURE FOR PHOTOELECTRIC CONVERSION ELEMENT, PHOTOELECTRIC CONVERSION ELEMENT, AND PHOTOELECTRIC CONVERSION ELEMENT MODULE**

(30) Priority: 03.08.2010 JP 2010174474
(71) Applicant: Nippon Steel & Sumikin Chemical Co., Ltd., Chiyoda-ku Tokyo 101-0021 (JP)
(72) Inventor: YAMAGUCHI, Yoshihiro, Kitakyusyu-shi Fukuoka 804-8503 (JP); FUJINO, Ken-ichi, Kitakyusyu-shi Fukuoka 804-8503 (JP); FUJITAKA, Toshihisa, Kitakyusyu-shi Fukuoka 804-8503 (JP)
(74) Representative: Giles, Ashley Simon
(86) International application number: PCT/JP2011/004068
(87) International publication number: WO 2012/017610

(57) **Abstract**

Provided is a sealing structure of a photoelectric conversion element in which the open side end section of the photoelectric conversion element can be surely and continuously sealed by a simple structure with high durability, and also the problem of insufficient sealing of the extraction electrode can be solved. A sealing structure 10 of a dye-sensitized solar cell as an example of the photoelectric conversion element is configured by a cylindrical dye-sensitized solar cell main body 12 and sealing sections 14a and 14b which respectively seal both ends of the dye-sensitized solar cell main body 12. Lid bodies 26a and 26b, each of which is formed of a conductive metal member, are respectively provided at both end sections of a transparent glass tube 16, so as to seal the dye-sensitized solar cell main body 12, and are also respectively electrically connected to a pair of electrode sections of the dye-sensitized solar cell main body 12, so as to be used as a pair of extraction electrodes.

## Description

### Technical Field

The present invention relates to a sealing structure for a photoelectric conversion element, and also relates to a photoelectric conversion element and a photoelectric conversion element module, each of which has the sealing structure.

### Background Art

A dye-sensitized solar cell is referred to as a wet-type solar cell or a Graetzel cell, and is featured in that it has an electrochemical cell structure as represented by a cell structure using an iodine solution and without using a silicon semiconductor. For example, the dye-sensitized solar cell has a simple structure in which an iodine solution, or the like, is arranged as an electrolyte between a porous semiconductor layer, such as a titania layer formed by baking titanium dioxide powder, or the like, onto an anode electrode, such as a transparent conductive glass plate, and then making a dye adsorbed in the baked powder, and a counter electrode (cathode electrode) made of a conductive glass plate (conductive substrate).

The dye-sensitized solar cell has been attracting attention as a low-cost solar cell because the dye-sensitized solar cell uses inexpensive materials and does not need large-scale equipment for manufacturing the dye-sensitized solar cell.

However, the conventional dye-sensitized solar cell mainly has a plate-like structure, and hence requires a large installation area. Further, the conventional dye-sensitized solar cell has a disadvantage that the amount of power generation of the solar cell is not stabilized because the amount and incident angle of sunlight, which is the energy source of the solar cell, are changed according to the time and the season.

In view of the above-described disadvantages of the conventional dye-sensitized solar cell, there is proposed a dye-sensitized solar cell (see, for example, Patent Literature 1) having a cylindrical structure in which an anode electrode layer, a dye-sensitized porous semiconductor layer, and an electrolyte layer are successively provided on the inner surface of a tube made of a transparent material, and in which a cathode electrode is inserted into the central portion of the tube.

With the dye-sensitized solar cell having such cylindrical structure, it is possible to provide a dye-sensitized solar cell which can significantly reduce the change of the power generation amount with respect to the incident angle of sunlight, and which also has higher strength, fewer sealing portions, and higher durability as compared with the dye-sensitized solar cell having the plate-like structure.

In the cylindrically-structured dye-sensitized solar cells including the above-described example, the open ends on both sides of the cylindrical structure are sealed with a resin adhesive.

However, the resin adhesive generally lacks in durability because it is affected by environmental changes and is deteriorated with time. Therefore, the cylindrically-structured dye-sensitized solar cell has a problem that the electrolyte is likely to leak from the sealing portion.

In order to solve such a problem, there is proposed a photoelectric conversion element (see Patent Literature 2) having a sealing structure in which the opening end section of the cylindrical element is sealed by a screw structure, and more preferably an O-ring is arranged at the opening end section.

In this case, although not specified in Patent Literature 2, it is considered to be necessary that, similarly to the other example described above, a pair of extraction electrodes, which are respectively connected to a pair of an anode electrode and a cathode electrode, are each provided so as to be exposed from the sealing portions, and hence are each extracted by providing through holes, and the like, in the sealing portions. Therefore, from the viewpoint of leakage of the electrolyte, there remains anxiety about the sealing structure of the through holes, and the like.

As a photoelectric conversion element configured to improve this disadvantage, there is proposed a dye-sensitized solar cell module (see Patent Literature 3) having a sealing structure in which a through hole is provided in a case with a cell block enclosed therein, in which a metallic nut is attached to the outer side of the through hole by using a glass frit, and also a metallic bolt that is screwed into the nut is provided, and in which the electrode lead wire extracted from the inside of the case is inserted into the extraction hole formed in the metallic bolt, and then the air gap in the extraction hole is filled with the glass frit. However, the technique required to manufacture such sealing structure is complicated.

### Citation List

### Patent Literature

Patent Literature 1: Japanese Patent Laid-Open No. 2003-77550
Patent Literature 2: Japanese Patent Laid-Open No. 2010-40391
Patent Literature 3: Japanese Patent Laid-Open No. 2010-114034

### Summary of Invention

### Technical Problem

An object of the present invention is to solve the problem that the sealing performance of the sealing structure of the open ends on both sides of a photoelectric conversion element, such as the conventional cylindrical dye-sensitized solar cell, is not sufficient, or the problem that the durability of the sealing structure against a change with the passage of time is not always sufficient, or the problem that the technique required to manufacture the sealing structure is complicated.

### Solution to Problem

A sealing structure of a photoelectric conversion element according to the present invention is featured in that a side surface of a cylindrical or conical transparent member is used as a light receiving surface, and photoelectric conversion cell components are arranged in layers in the transparent member in a radial direction of the transparent member,
in that a pair of lid bodies are respectively provided at both end sections of the transparent member, and
in that each of the pair of lid bodies has a conductive metal section extending in an axial direction of the transparent member, one end side of the conductive metal section being electrically connected to one of a pair of electrodes of the photoelectric conversion cell components so as to be used as an extraction electrode.

Further, a sealing structure of a photoelectric conversion element according to the present invention is featured in that a side surface of a cylindrical or conical transparent member having one closed end side is used as a light receiving surface, and photoelectric conversion cell components are arranged in layers in the transparent member in a radial direction of the transparent member,
in that a lid body section is provided at an open end section of the transparent member, and
in that the lid body section includes two mutually insulated conductive metal sections extending to penetrate the lid body section in an axial direction of the transparent member, one end side of one of the conductive metal sections being used as an extraction electrode by being electrically connected to one electrode of the photoelectric conversion cell components, and one end side of the other of the conductive metal sections being used as an extraction electrode by being electrically connected to the other electrode of the photoelectric conversion cell components.

Further, the sealing structure of the photoelectric conversion element according to the present invention is featured in that the photoelectric conversion element is preferably a dye-sensitized solar cell, and the photoelectric conversion cell components include a porous semiconductor layer adsorbing a dye, an electrolyte layer, and a pair of electrode layers.

Further, the sealing structure of the photoelectric conversion element according to the present invention is featured in that the photoelectric conversion element is preferably a dye-sensitized solar cell, and the photoelectric conversion cell components include a porous semiconductor layer adsorbing a dye, an electrolyte layer, and a pair of electrode layers,
in that a counter electrode layer of the pair of electrode layers is set as the innermost layer, and is supported by an insulating material inserted into an inner side of the counter electrode layer, and one end section of an anode electrode of the pair of electrode layers is converged to form a converging section, and
in that each of the pair of lid bodies is formed to have a two-body structure of an inner lid section and an outer lid section, the two body structure being configured such that the inner lid section of one of the lid bodies is brought into sliding contact with the inner side of the counter electrode layer so as to be electrically connected to the counter electrode layer and so as to be exposed from an opening formed in the outer lid section of the one of the lid bodies, such that the inner lid section of the other of the lid bodies is pressed to the converging section of the anode electrode so as to be electrically connected to the anode electrode and so as to be exposed from an opening formed in the outer lid section of the other of the lid bodies, and such that an end section of the outermost layer of the photoelectric conversion cell components is closed by the outer lid section of each of the pair of lid bodies.

Further, the sealing structure of the photoelectric conversion element according to the present invention is featured in that the lid body preferably has a through hole which is made to communicate with the electrolyte layer and to penetrate the lid body in the axial direction of the transparent member, and in that a check valve is attached to the through hole, and the through hole is sealed by a cap.

A photoelectric conversion element according to the present invention is featured by including one of the above-described sealing structures of the photoelectric conversion element.

A photoelectric conversion element module according to the present invention is featured in that a plurality of the photoelectric conversion elements described above are arranged in series or in parallel with each other via electrode leads connected to the extraction electrodes.

### Advantageous Effects of Invention

In the sealing structure of the photoelectric conversion element according to the present invention, the lid body or the lid body section for sealing the open end section of the photoelectric conversion element formed in a cylindrical shape, or the like, is provided, and the lid body, or the like, has the conductive metal section extending in the axial direction, and one end side of the conductive metal section is electrically connected to the electrode of the photoelectric conversion cell components, so as to be used as an extraction electrode. Therefore, the open end section of the photoelectric conversion element can be surely and continuously sealed by a simple structure with high durability, and the problem of insufficient sealing of the extraction electrode can also be solved.

Further, with the photoelectric conversion element and the photoelectric conversion element module according to the present invention, each of which has one of the above-described sealing structures, it is possible to suitably obtain the effects of the sealing structure.

### Brief Description of Drawings

[Figure 1] Figure 1 is a view for explaining a sealing structure of a dye-sensitized solar cell according to a first example of a present embodiment.
[Figure 2] Figure 2 is a view for explaining a second modification of the sealing structure of the dye-sensitized solar cell according to the first example of the present embodiment.
[Figure 3] Figure 3 is a view for explaining a sealing structure of a dye-sensitized solar cell according to a second example of the present embodiment.
[Figure 4] Figure 4 is an exploded sectional view of sealing components used in the sealing structure of the dye-sensitized solar cell according to the second example of the present embodiment.
[Figure 5] Figure 5 is a view for explaining a first modification of the sealing structure of the dye-sensitized solar cell according to the first example of the present embodiment.
[Figure 6] Figure 6 is an exploded view of the first modification of the sealing structure of the dye-sensitized solar cell according to the first example of the present embodiment.
[Figure 7] Figure 7 is an exploded view of a third modification of the sealing structure of the dye-sensitized solar cell according to the first example of the present embodiment.
[Figure 8] Figure 8 is a view for explaining a fourth modification of the sealing structure of the dye-sensitized solar cell according to the first example of the present embodiment.

### Description of Embodiment

In the following, an embodiment according to the present invention (hereinafter referred to as examples of a present embodiment) will be described with reference to the accompanying drawings.

A photoelectric conversion element having a sealing structure according to the present embodiment is basically configured such that the side surface of a cylindrical or conical transparent member is used as a light receiving surface, and such that photoelectric conversion cell components are arranged in layers in the transparent member in the radial direction of the transparent member.

The photoelectric conversion cell components can be suitably configured. Examples of the photoelectric conversion section of the photoelectric conversion cell components include single crystal silicon, polycrystalline silicon, thin film silicon, various thin films, and dye sensitizing material.

As compared with the conventional flat-plate type or flat-panel type photoelectric conversion element, the so-called fiber type or tube type photoelectric conversion element described above is configured by the cell components, such as electrode layers, which can be easily manufactured and are also advantageous in electrical characteristics in the case where the size of the photoelectric conversion element is increased. Further, the fiber type or tube type photoelectric conversion element can significantly reduce the change in the power generation amount with respect to the incident angle of light, and has higher strength, fewer sealing portions, and higher durability as compared with the flat-plate type photoelectric conversion element.

The sealing structure of the photoelectric conversion element is principally configured as follows. In the sealing structure, a lid body (lid body section) for sealing one or both open ends of the cylindrical or conical transparent member is provided. The lid body has a conductive metal section extending in the axial direction of the transparent member, and one end of the conductive metal section is electrically connected to an electrode of the photoelectric conversion cell components. The conductive metal section of the lid body is used as an extraction electrode.

In the following, the present embodiment will be described by taking a dye-sensitized solar cell as an example of the photoelectric conversion element.

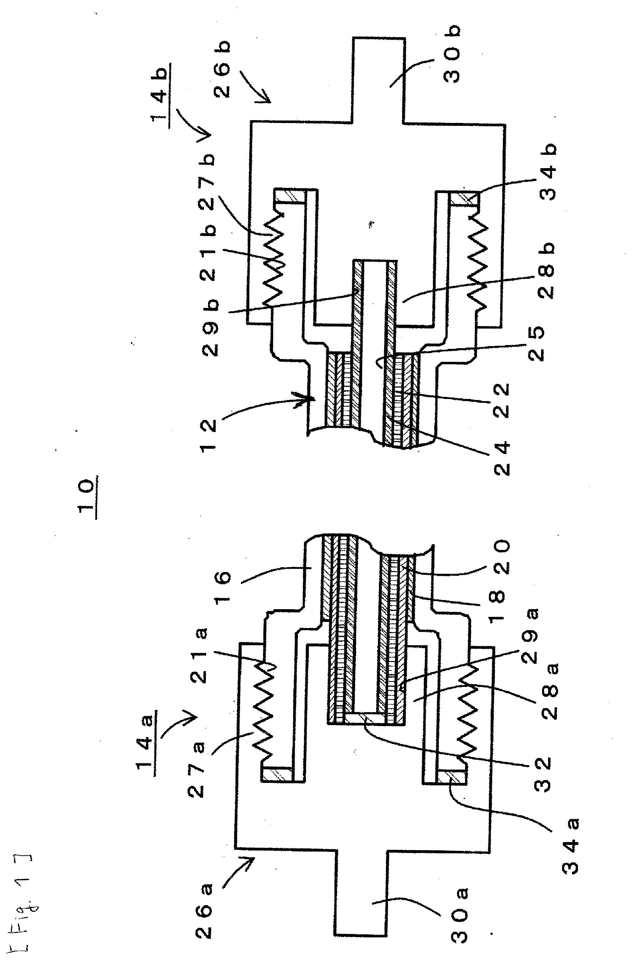

First, a sealing structure of a dye-sensitized solar cell according to a first example of the present embodiment is described with reference to Figure 1.

A sealing structure 10 of a dye-sensitized solar cell according to a first example of the present embodiment shown in Figure 1 is configured by a cylindrical dye-sensitized solar cell main body 12, and sealing sections 14a and 14b for sealing both ends of the dye-sensitized solar cell main body 12.

In the dye-sensitized solar cell main body 12, a porous semiconductor layer 18 adsorbing a dye, a current collecting electrode (anode electrode, electrode layer, conductive metal layer) 20, an insulating layer 22, and a counter electrode layer (electrode layer) 24 are laminated on the inner side of a cylindrical transparent glass tube (transparent member) 16 in this order in the radial direction of the cylindrical transparent glass tube 16. As the current collecting electrode 20, a member, such as for example a perforated plate, which has suitable rigidity and on which a perforated conductive metal layer is provided, is used. Further, the counter electrode layer 24 may be a hollow cylinder as illustrated in Figure 1 or may also be a solid cylinder as long as it has suitable rigidity. Further, the counter electrode layer 24 may be a roll formed by winding a sheet-like material. Each of the current collecting electrode 20 and the insulating layer 22 is made porous.

Note that, although not shown, a space between the current collecting electrode (anode electrode) 20 and the counter electrode layer is filled with an electrolyte (electrolyte layer).

Each end section of the transparent glass tube 16 is formed in a stepped shape in which the diameter of the end section is larger than the diameter of the portion housing therein each of the above-described cell components. Also, each of male screw threads 21a and 21b is formed on the outer periphery of each of the end sections of the transparent glass tube 16.

The configuration of the dye-sensitized solar cell main body 12 is not limited in particular, and a known configuration can be suitably adopted.

The transparent glass tube 16 is preferred because it is excellent in durability, but, for example, a transparent rigid resin tube may also be used in place of the transparent glass tube 16.

Further, for example, a TCO electrode, which is formed by providing a transparent electrode on the inner side of the transparent glass tube 16, may also be used in place of the current collecting electrode 20 which is a so-called three-dimensional electrode.

Further, a material suitably selected from known materials can be used as the material of each of the members.

Lid bodies 26a and 26b are respectively provided at both end sections (open end sections) of the transparent glass tube 16. Each of the both end sections of the transparent glass tube 16 and each of the lid bodies 26a and 26b configure a sealing structure (sealing section).

Each of the lid bodies 26a and 26b is formed by a conductive metal member (conductive metal section). In this case, only a part of each of the lid bodies 26a and 26b, which part extends in the axial direction of the transparent glass tube 16, may be formed of a conductive metal member. The material of the conductive metal member of each of the lid bodies 26a and 26b is not limited in particular as long as the material has a good conductive property and is not soluble in the electrolyte. For example, one or more materials selected from a group of Ti, W, Ni, Pt, Ta, Nb, Zr, Fe, Cu, Cr and Au, or a compound of these materials can be suitably used. Further, when a metal material which may be corroded by the electrolyte is used, a metal material having good corrosion resistance may be sputtered, plated, vapor-deposited, or the like on the surface of the metal material.

In each of the lid bodies 26a and 26b which is a cap provided with a female screw, each of screw threads 27a and 27b engaging each of the screw threads 21a and 21b is formed on the inner side surface of the cylindrical member whose one end section is closed. Protrusions 28a and 28b, at the distal end of which recessed sections 29a and 29b having different diameters are respectively formed, are respectively provided at the inner center of the lid bodies 26a and 26b. On the other hand, protrusions 30a and 30b are also respectively provided at the outer center of the lid bodies 26a and 26b. However, the protrusions 30a and 30b are needed for the other purpose described below, but are fundamentally unnecessary. Note that, as long as the inner cross-sectional shape of each of the lid bodies 26a and 26b is a circular shape, the outer cross-sectional shape of each of the lid bodies 26a and 26b may be a circular shape, or a polygonal shape. This point is the same as in the other examples. Further, each of the lid bodies 26a and 26b may be configured to be fitted into the transparent glass tube 16. In this case, a male screw is formed on each of the lid bodies 26a and 26b, and a female screw is formed at each end sections of the transparent glass tube 16.

Among the respective cell components on the side of the lid body 26a, the end section of each of the other cell components, except the porous semiconductor layer 18 adsorbing the dye, is formed to have a dimension such that the end section is extended to be accommodated in the recessed section 29a of the protrusion 28a in a sliding contact manner. On the other hand, the end section of the counter electrode layer 24 of the cell components on the side of the lid body 26b is formed to have a dimension such that the end section is extended to be accommodated in the recessed section 29b of the protrusion 28b in a sliding contact manner.

The lid bodies 26a and 26b are attached to the dye-sensitized solar cell main body 12 by the following procedures.

An insulating packing 32 is arranged at the end section of the counter electrode layer 24. Further, in the state where packing 34a is arranged at the outer periphery of the protrusion 28a, the lid body 26a is externally fitted to the left end section of the transparent glass tube 16 in Figure 1, and thereby the end sections of the other cell components, except the porous semiconductor layer 18 adsorbing the dye, are accommodated in the recessed section 29a of the protrusion 28a in a sliding contact manner. Note that as the packing 34a, a suitable member, such as a sheet gasket and an O-ring, can be used. The shape of packing in the other examples described below is the same as the shape of packing in this example. Here, as materials of the insulating packing 32, the packing 34a (including packing 34b), and the like, it is possible to use Teflon (Teflon is a registered trademark), foamed Teflon (Teflon is a registered trademark), nitrile rubber, a silicon material, polyethylene, polypropylene, and the like. However, it is particularly preferred to use a material coated with Teflon having excellent corrosion resistance against the electrolyte. This point is similarly applied to packing used in the other examples described below.

Further, a sealing tape may also be provided in the area ranging from the engagement portion between each of the male screw threads 21a and 21b of the transparent glass tube 16, and each of the female screw threads 27a and 27b of the lid bodies 26a and 26b, to the contact surface between the transparent glass tube 16 and each of the lid bodies 26a and 26b, which contact surface is located in the vicinity of the engagement portion. The material of the sealing tape is not limited in particular as long as it has excellent corrosion resistance against the electrolyte, but Teflon is preferably used.

With this configuration, the end section of the transparent glass tube 16 is sealed by the lid body 26a, and also the recessed section 29a of the protrusion 28a of the lid body 26a is brought into contact with the current collecting electrode 20. Thereby, the lid body 26a is electrically connected to the current collecting electrode 20, so as to be used as an extraction electrode of the current collecting electrode 20. For example, the protrusion 30a of the lid body 26a is used as a terminal to which an electrode lead can be connected. Note that the short circuit between the counter electrode layer and the lid body 26a is prevented by the insulating packing 32.

On the other hand, in the state where the packing 34b is arranged around the outer periphery of the protrusion 28b, the lid body 26b is externally fitted to the right end section of the transparent glass tube 16 in Figure 1, so that the end sections of the counter electrode layer and the insulating layer 24 are accommodated in the recessed section 29b of the protrusion 28b in a sliding contact manner.

Thereby, the end section of the transparent glass tube 16 is sealed by the lid body 26b, and the lid body 26b is electrically connected to the counter electrode by the contact between the recessed section 29b of the protrusion 28b of the lid body 26b and the counter electrode layer, so that the lid body 26b is used as the extraction electrode of the counter electrode. For example, the protrusion 30b of the lid body 26b is used as a terminal to which an electrode lead can be connected.

The above-described sealing structure 10 of the dye-sensitized solar cell, according to the first example of the present embodiment, can provide a simple configuration being able to surely and continuously seal the open end sections of the dye-sensitized solar cell, and having high durability, and can also solve the problem of insufficient sealing of the extraction electrode.

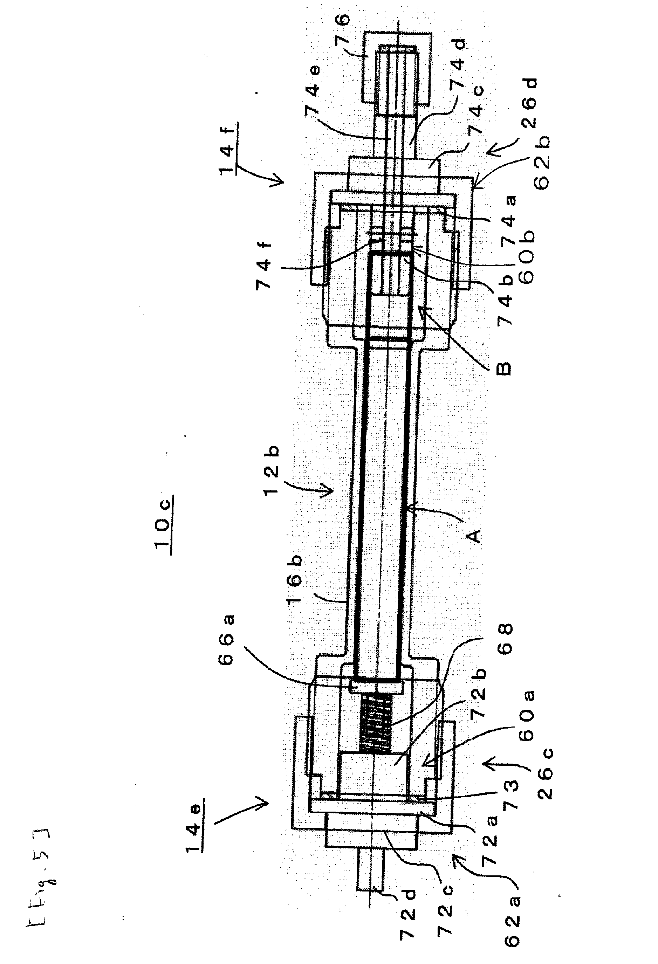

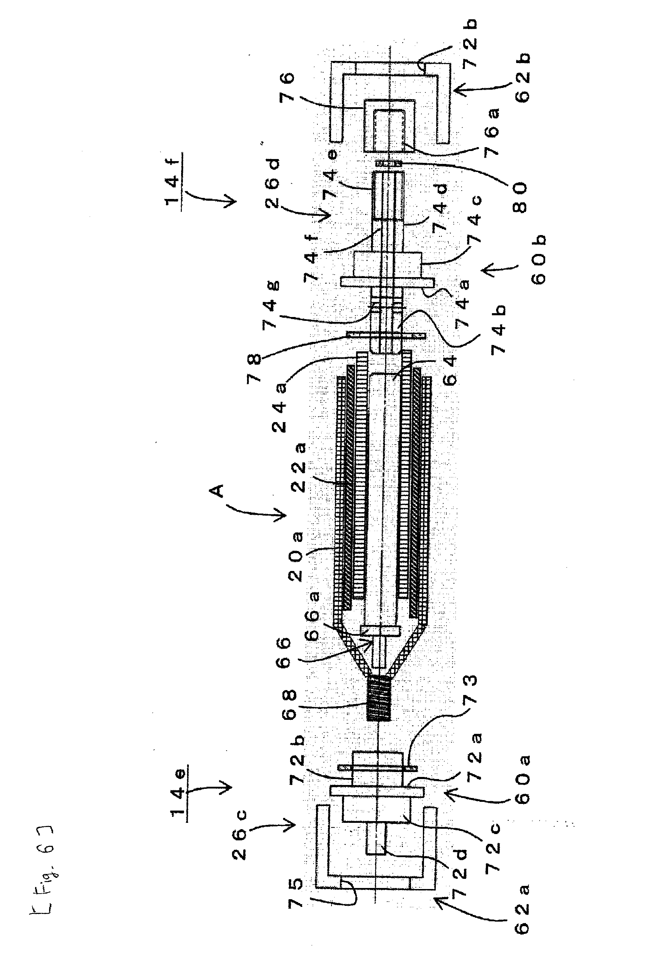

Next, a first modification of the sealing structure 10 of the dye-sensitized solar cell according to the first example of the present embodiment will be described with reference to Figure 5 and Figure 6.

A sealing structure 10c of a dye-sensitized solar cell, according to a first modification shown in a schematic configuration view of Figure 5, and an exploded view of Figure 6, has substantially the same configuration as that of the sealing structure 10 of the dye-sensitized solar cell, except that a pair of lid bodies 26c and 26d of sealing sections 14e and 14f have two-body structures which are respectively configured by inner lid sections 60a and 60b, and outer lid sections 62a and 62b respectively covering the inner lid sections 60a and 60b. For this reason, the explanation of the portions overlapping with the sealing structure 10 of the dye-sensitized solar cell is omitted. Note that illustration of a transparent glass tube 16b shown in Figure 5 is omitted in Figure 6.

In the following, the sealing structure 10c of the dye-sensitized solar cell will be described together with the assembling method of the sealing structure 10c.

In a dye-sensitized solar cell main body 12b, cell members (shown by an arrow A in Figure 5 and Figure 6) configured except the transparent glass tube 16b include a current collecting electrode (anode electrode) 20a, an insulating layer 22a, and a counter electrode layer 24a. Note that illustration of a porous semiconductor layer adsorbing a dye, and an electrolyte is omitted.

A rod-shaped insulator 64, which supports the counter electrode layer 24a, is inserted into the counter electrode layer 24a. A protrusion 66 with a flange 66a is provided at the left end section of the insulator 64. The right end section of the insulator 64 is retreated from the end section of the counter electrode layer 24a. A portion of the current collecting electrode 20a, which portion is located on the side of the protrusion 66 with the flange 66a, is converged to form a converging section.

A coil spring 68 formed of a conductive material is wound around the distal end of the protrusion 66. The left end section of the current collecting electrode 20a is converged to be joined to one end side of the coil spring 68.

The inner lid section 60a of the lid body 26c is formed of a conductive material, and a protrusion 72b is provided on the right side of a flange 72a. Protrusions 72c and 72d, which are formed in a stepped shape, are provided on the left side of the flange 72a. The outer lid section 62a is a cylindrical member which is formed of a suitable material, such as an insulating material, and one end section of which is closed. A through hole 75 is formed in the closed bottom surface of the outer lid section 62a. Note that reference numeral 73 denotes packing.

The inner lid section 60b of the lid body 26d is formed of a conductive material, and a protrusion 74b is provided on the left side of a flange 74a. Protrusions 74c and 74d, which are formed in a stepped shape, are provided on the right side of the flange 74a. A male screw thread 74e is provided on the outer periphery of the protrusion 74d. A through hole 74f, which penetrates the protrusion 74b, the flange 74a, and the protrusions 74c and 74d, is formed and made to communicate with the outside through the side surface of the protrusion 74b by a hole 74g provided in the side surface of the protrusion 74b. The inner lid section 60b further includes a cap 76 which covers the protrusion 74d and which is formed of a conductive material. A female screw thread 76a is formed on the inner surface of the cap 76. The outer lid section 62b is a cylindrical member one end section of which is closed. The through hole 72b is formed in the closed bottom surface of the outer lid section 62b. Note that each of reference numerals 78 and 80 denotes packing.

In the assembled state of the sealing structure 10c of the dye-sensitized solar cell, the coil spring 68 is pressed to the flange 66a by the protrusion 72b of the inner lid section 60a. On the other hand, the protrusions 72c and 72d are made to project from the through hole 75. The inner lid section 60a is covered with the outer lid section 62a, and the outer lid section 62a is screwed to the transparent glass tube 16b (illustration of the screw-fixing structure is omitted). Thereby, the current collecting electrode 20a is electrically connected to the inner lid section 60a via the coil spring 68, and the inner lid section 60a acts as an extraction electrode. Note that the inner lid section 60a, the outer lid section 62a, and the transparent glass tube 16b are sealed from each other by the packing 73.

On the other hand, the protrusion 74b of the inner lid section 60b is inserted into the counter electrode layer 24a so as to be in sliding contact with the counter electrode layer 24a, and thereby the counter electrode layer 24a is electrically connected to the inner lid section 60b. The cap 76 is attached to the protrusion 74d of the inner lid section 60b, so that the inner lid section 60b is electrically connected to the cap 76. The outer lid section 62b is attached to cover the inner lid section 60b, and the protrusions 74c and 74d of the inner lid section 60b and the cap 76 are made to project from the outer lid section 62b through the through hole 72b. The outer lid section 62b is screwed to the transparent glass tube 16b (illustration of the screw structure is omitted). Thereby, the inner lid section 60b acts as an extraction electrode. Note that the inner lid section 60b, the outer lid section 62, and the transparent glass tube 16b are sealed from each other by the packing 78, and the protrusion 74d and the cap 76 are sealed from each other by the packing 80. A space section (shown by an arrow B in Figure 5.) is formed between the transparent glass tube 16b and the protrusion 74b, so as to communicate with the through hole 74f via the through hole 74g in the space section B. Therefore, the space section B provides a buffering function, such as the function of discharging the electrolyte which swells due to temperature variation.

The sealing structure 10c of the dye-sensitized solar cell according to the first modification can suitably provide the effect of the sealing structure 10 of the dye-sensitized solar cell according to the first example of the present embodiment.

Further, in the sealing structure 10c of the dye-sensitized solar cell, there is no possibility that the current collecting electrode and the counter electrode layer are deformed or damaged due to a force such as torsion at the time of assembly and that a sealing failure or the like is caused due to the deformation or the damage. Further, the weight and material cost of the sealing structure 10c of the dye-sensitized solar cell can be reduced as compared with the sealing structure 10 of the dye-sensitized solar cell according to the first example of the present embodiment, in which all the lid bodies are formed of conductive metal members. Further, the distal end of the inner lid section 60b has a screw structure and the through hole 74f formed therethrough, and hence a check valve can also be mounted at the distal end of the inner lid section 60b.

Note that the sealing structure of the first modification, in which the lid body is configured by two bodies of the inner lid section and the outer lid section, can also be applied to the other examples.

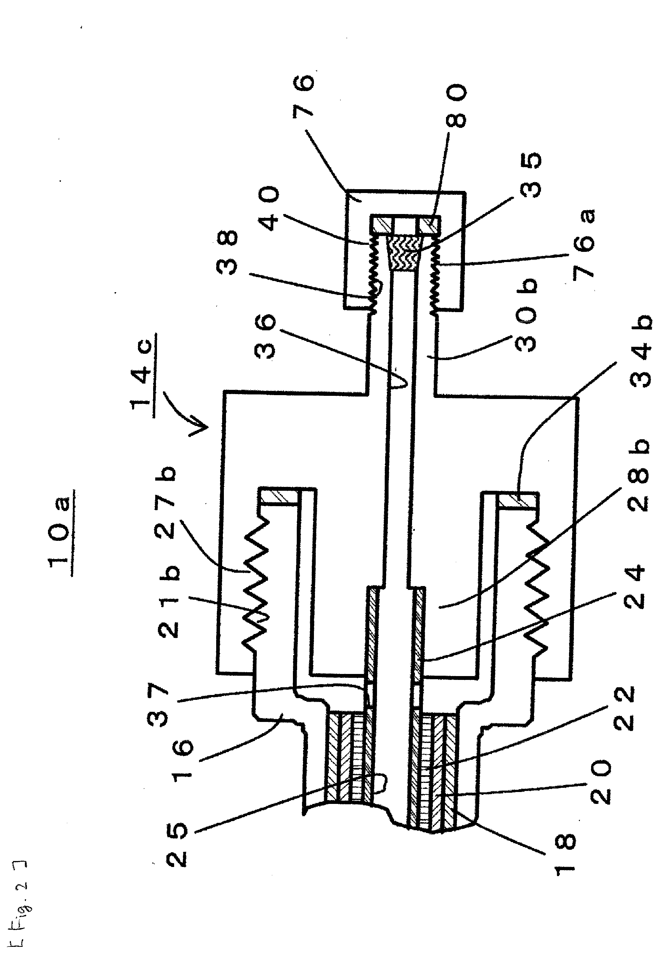

Next, a second modification of the sealing structure 10 of the dye-sensitized solar cell according to the first example of the present embodiment will be described with reference to Figure 2.

A sealing structure 10a of a dye-sensitized solar cell, according to a second modification shown in Figure 2, has substantially the same configuration as that of the sealing structure 10 of the dye-sensitized solar cell, except that a through hole 36, a check valve 35, the packing 80, and the cap 76 are provided on each of the lid bodies 26a and 26b of the sealing structure 10.

For this reason, the explanation of the portions overlapping with the sealing structure 10 of the dye-sensitized solar cell is omitted. Note that only the side of the lid body 26b of the sealing structure 10 is shown in Figure 2 and is described in the following, but the structure on the side of the lid body 26a is the same as that on the side of the lid body 26b.

The counter electrode layer 24 has a hole 37.

In the lid body 26b of a sealing section 14c, the through hole 36 is formed along the axial line. The through hole 36 is made to communicate with the inner space of the counter electrode layer 24. Thereby, the electrolyte is made to flow through the inner space of the counter electrode layer 24 and the through hole 36 via the through hole 37. A male screw thread 38 is formed on the outer periphery of the distal end section of the protrusion 30b of the lid body 26b. The lid body 26b is externally fitted to the transparent glass tube 16 so that the through hole 36 is made to communicate with an inner space 25 of the counter electrode layer.

The check valve 35 is externally fitted to and inserted in the portion of the through hole 36 of the protrusion 30b. Further, a male screw thread 40 is formed on the protrusion 30b, and the female screw thread 76a is formed on the inner side of the cap 76.

When light is irradiated onto the dye-sensitized solar cell, the temperature in the cell is increased. As a result, the internal pressure is increased by the thermal expansion of the electrolyte solution, which becomes a cause of leakage of the electrolyte solution. Further, once the leakage of the electrolyte solution is caused, air and moisture are likely to be mixed into the electrolyte solution through the gap through which the leakage is caused, and thereby the cell life is significantly reduced. The increased internal pressure can be released simply by the through hole and the check valve, to thereby prevent air and moisture from being mixed into the electrolyte solution from the outside. For example, the internal pressure increased by injection of the electrolyte solution and the internal pressure increased during use of the cell can be released during or after the use of the cell. Therefore, the cell can be used for a long period of time.

A specific example of manufacturing the sealing structure 10a of the dye-sensitized solar cell according to the second modification will be described.

Titanium is sputtered onto both surfaces of a stainless steel mesh (current collecting electrode) having a longitudinal length of 30 mm, a lateral length of 100 mm, and a thickness of 40 µm, so as to have a thickness of 300 nm. Then, a titania paste is applied to one of the sputtered surfaces of the mesh so as to have a dried film thickness of 15 µm, and is then sintered at 500°C for 30 minutes, so that titania (a porous semiconductor layer) is formed. Thereafter, the stainless steel mesh with the titania is immersed in 0.05 wt% of a dye solution (black dye, acetonitril made by SOLARONIX Co., Ltd. : t-butyl alcohol = 1:1) for 72 hours.

On the other hand, a counter electrode formed by sputtering platinum onto a titanium foil (having purity of 99.5% or more) having a longitudinal length of 31 mm, a lateral length of 110 mm, and a thickness of 40 µm, and an insulating sheet (insulating layer) having a longitudinal length of 32 mm, a lateral length of 110 mm, and a thickness of 32 µm are prepared.

The current collecting electrode, which is rolled in the state where the surface provided with titania is directed toward the outer side with respect to the counter electrode, is inserted into a glass tube which has an inner diameter of 10.4 mm x a straight tube length of 90 and both ends of which are threaded. Further, the insulating sheet rolled into a tubular shape is slowly inserted into the inner side of the current collecting electrode, and the counter electrode rolled into a tube shape is inserted into the inner side of the insulating sheet rolled into the tubular shape. Note that the current collecting electrode, the insulating sheet, and the counter electrode layer are disposed on one side of the glass tube, and the counter electrode layer is disposed on the other side of the glass tube.

Note that, on the side on which the current collecting electrode and the insulating layer are disposed, insulating packing is provided so as to prevent that the counter electrode layer and the current collecting electrode are contacted and short-circuited with each other. The side of the glass tube on which side the current collecting electrode and the insulating layer are disposed, and the side of the glass tube on which side the counter electrode layer is disposed are each firmly plugged by a threaded cap (lid body) made of titanium. After injection of an electrolyte made of a 3-methoxypropionitrile solution containing 40 mM of iodine, 500 mM of LiI, and 580 mM of t-Butylpyridine, a check valve (CCRM2550269S manufactured by Lee Co., Ltd.) is inserted into the through hole of the lid body in the direction such that gas or electrolyte solution is allowed to flow from the inner side to outer side of the through hole and is prevented from flowing from the outer side to the inner side. The check valve is fixed by hitting the head of the check valve with a wooden hammer. The cap is closed by arranging packing at the portion of the check valve, so that the dye-sensitized solar cell (battery cell) is manufactured.

In the above-described sealing structure 10a of the dye-sensitized solar cell according to the second modification, when the temperature of the cell is increased by irradiation of light onto the cell and thereby the internal pressure of the cell is increased due to the thermal expansion of the electrolyte, the check valve 35 acts as a pressure relief valve by loosening the cap, and hence the transparent glass tube 16 can be prevented from being broken.

Note that the sealing structure 10a of the dye-sensitized solar cell can be similarly applied to a sealing structure 10b of a dye-sensitized solar cell according to a second example of the present embodiment described below.

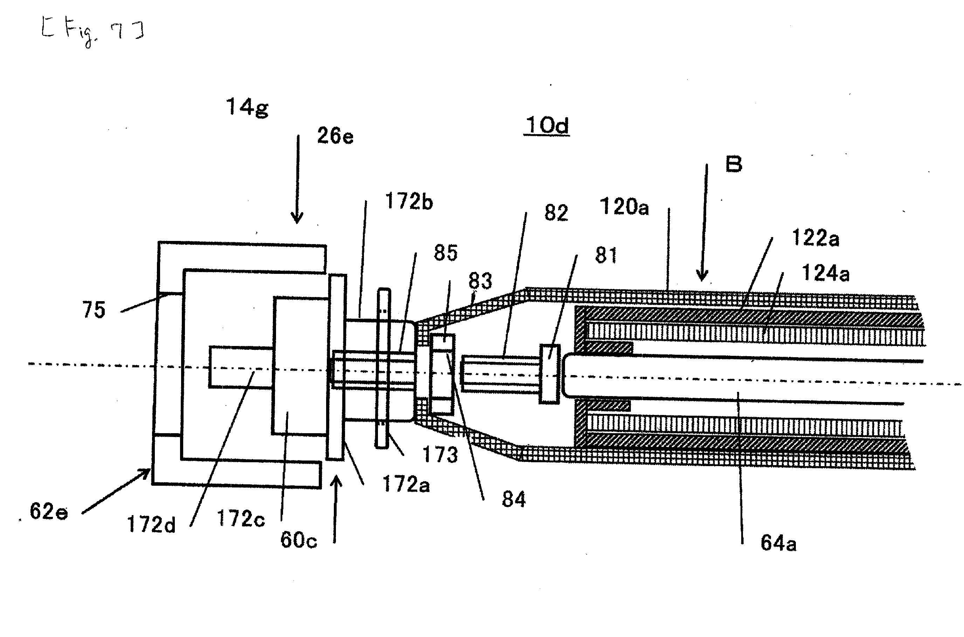

Next, a third modification of the sealing structure 10 of the dye-sensitized solar cell according to the first example of the present embodiment will be described with reference to Figure 7. A sealing structure 10d of a dye-sensitized solar cell according to a third modification is substantially similar to the sealing structure 10 of the dye-sensitized solar cell according to the first example of the present embodiment, and is configured by a cylindrical dye-sensitized solar cell main body and a sealing section 14g which seals the open end of the dye-sensitized solar cell main body.

The sealing structure 10d of the dye-sensitized solar cell, according to the third modification shown in Figure 7, has the same configuration as that of the sealing structure 10c of the dye-sensitized solar cell, except that, when a current collecting electrode 120a and a protrusion 172b are connected to each other, the coil spring 68 as used in the sealing structure 10c is not used, but the current collecting electrode 120a and the protrusion 172b are directly connected to each other in such a manner that screw threads 82 and 85 are respectively provided at a bolt-shaped member 81 and the protrusion 172b, and that the current collecting electrode 120a is sandwiched between the protrusion 172b and a current collecting electrode presser 83 so as to be fixed by the bolt-shaped member 81. For this reason, the explanation of the portions overlapping with the sealing structure 10c of the dye-sensitized solar cell is omitted. Note that illustration of the transparent glass tube 16b as shown in Figure 5 is omitted in Figure 7.

Note that, in Figure 7, reference numeral 122a denotes an insulating layer, reference numeral 26e denotes a lid body, reference numerals 172c and 172d denote protrusions, reference numeral 60c denotes an inner lid section, reference numeral 62e denotes an outer lid section, and reference numeral 172a denotes a flange.

A specific example of manufacturing the sealing structure 10d of the dye-sensitized solar cell according to the third modification will be described.

Titanium is sputtered onto both surfaces of a stainless steel mesh (current collecting electrode) having a longitudinal length of 30 mm, a lateral length of 100 mm, and a thickness of 36 µm, so as to have a thickness of 300 nm. Then, a titania paste is applied to one of the sputtered surfaces of the mesh so as to have a dried film thickness of 15 µm, and is sintered at 500°C for 30 minutes, so that titania (a porous semiconductor layer) is formed. Then, the stainless steel mesh with the titania is immersed in 0.05 wt% of a dye solution (black dye, acetonitril made by SOLARONIX Co., Ltd. : t-butyl alcohol = 1:1) for 72 hours.

On the other hand, a counter electrode formed by sputtering platinum onto a titanium foil (having purity of 99.5% or more) having a longitudinal length of 31 mm, a lateral length of 110 mm, and a thickness of 40 µm, and an insulating sheet (insulating layer) having a longitudinal length of 32 mm, a lateral length of 110 mm, and a thickness of 32 µm are prepared.

The current collecting electrode, which is rolled in the state where the surface provided with titania is directed toward the outer side with respect to the counter electrode, is inserted into a glass tube which has an inner diameter of 10.4 mm x a straight tube length of 90 mm and both ends of which are threaded. Further, the insulating sheet rolled into a tubular shape is slowly inserted into the inner side of the current collecting electrode, and the counter electrode rolled into a tubular shape is inserted into the inner side of the insulating sheet rolled into the tubular shape. In this case, the end section of the insulating sheet is folded into the inner side of the counter electrode. Further, a columnar insulator made of Teflon is inserted into the inner side of the counter electrode. Note that the current collecting electrode, the insulating sheet, and the counter electrode layer are disposed on one side of the glass tube, and the counter electrode layer is disposed on the other side of the glass tube.

Note that, on the side on which the current collecting electrode and the insulating layer are disposed, insulating packing is provided so as to prevent that the counter electrode layer and the current collecting electrode are contacted and short circuited with each other. On the side of the glass tube on which side the current collecting electrode is disposed, the current collecting electrode is sandwiched between the inner lid and the current collecting electrode presser so as to be fixed by a hex-head screw. The side on which the counter electrode layer is disposed is plugged by a threaded cap (lid body) made of titanium. After injection of an electrolyte made of a γ-butyrolactone solution containing 40 mM of iodine, 500 mM of LiI, and 580 mM of t-Butylpyridine, a check valve (CCRM2550269S manufactured by Lee Co., Ltd.) is inserted into the through hole of the lid body in the direction such that gas or electrolyte solution is allowed to flow from the inner side to outer side of the through hole and is prevented from flowing from the outer side to the inner side. The check valve is fixed by hitting the head of the check valve with a wooden hammer. The cap is closed by arranging packing at the portion of the check valve, so that the dye-sensitized solar cell (battery cell) is manufactured.

In the above-described sealing structure 10d of the dye-sensitized solar cell, according to the third modification, since the current collecting electrode and the inner lid section are brought into direct contact with each other, the resistance in the cell is reduced, and hence the power can be efficiently generated. Note that the sealing structure 10d of the dye-sensitized solar cell can be similarly applied to the sealing structure 10b of the dye-sensitized solar cell according to the second example of the present embodiment described below.

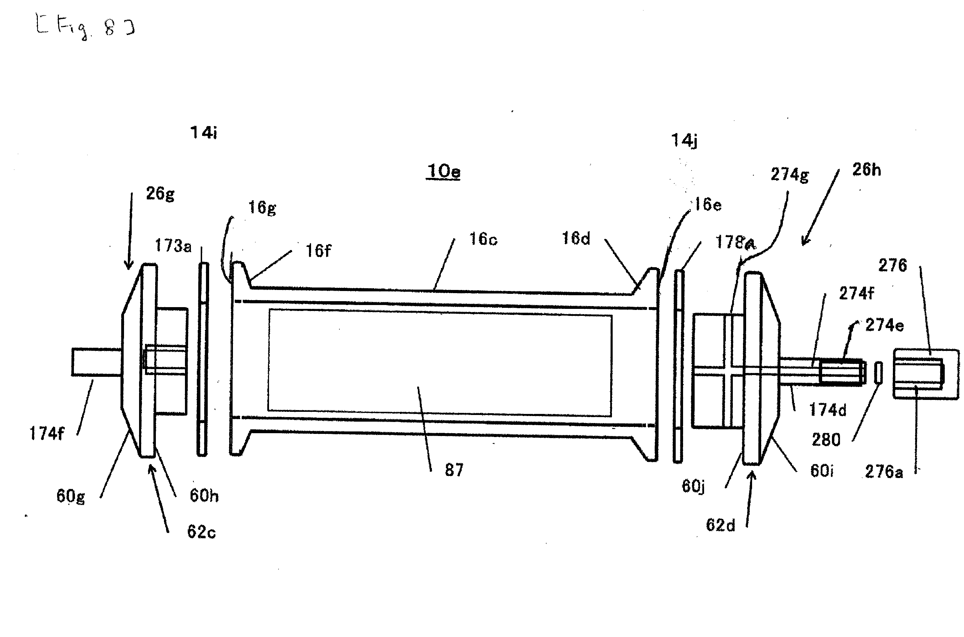

Next, a fourth modification of the sealing structure 10 of the dye-sensitized solar cell according to the first example of the present embodiment will be described with reference to Figure 8. A sealing structure 10e of a dye-sensitized solar cell, according to a fourth modification is substantially similar to the sealing structure 10 of the dye-sensitized solar cell according to the first example of the present embodiment, and is configured by a cylindrical dye-sensitized solar cell main body, and sealing sections 14i and 14j which respectively seal the open ends of the dye-sensitized solar cell main body.

The sealing structure 10e of the dye-sensitized solar cell, according to the fourth modification shown in Figure 8, has the same configuration as that of the sealing structure 10c of the dye-sensitized solar cell, except that the portion between an inner lid section 62c and a transparent glass tube 16c is sealed by packing 173a, the portion between an inner lid section 62d and the transparent glass tube 16c is sealed by packing 178a, and each of the sealing portions is sealed by being tightened by an outer lid section (not shown). For this reason, the explanation of the portions overlapping with the sealing structure 10c of the dye-sensitized solar cell is omitted. The sealing structure 10e is featured in that the sealing portion of the transparent glass tube is not formed by a screw fixing structure but is formed by flanges. Therefore, the structure of the sealing portion is simple and the sealing structure 10e can be manufactured at low cost. In the case of the sealing structure 10e, it is preferred that each of the sealing portions is sealed by being tightened by a suitable fixing device, such as a clamp chain. In this case, the fixing devices correspond to the outer lid sections 62a and 62b in the sealing structure 10c of the dye-sensitized solar cell. Further, instead of sealing the sealing portions by tightening with a suitable fixing device such as a clamp chain, the sealing portions can also be sealed in such a manner that holes are provided in flanges 16g, 16e, 60h, and 60j, and that the sealing portions are sealed by tightening the flanges by bolts. In this case, each of the sealing portions is sealed by using a gasket instead of packing.

Note that a screw thread 274e of a protrusion 174d similar to the screw thread 74e of the protrusion 74d of the sealing structure 10c, and the screw thread 76a of the cap 76 are provided.

Note that, in Figure 8, reference numeral 124a denotes a counter electrode layer, reference numerals 26g and 26h denote lid bodies, reference numeral 174f denotes a protrusion, reference numeral 276 denotes a cap, reference numerals 16d, 16f, 60g and 60i denote slopes, reference numerals 274f and 274g denote through holes, and reference numeral 280 denotes packing.

A specific example of manufacturing the sealing structure 10e of the dye-sensitized solar cell according to the fourth modification will be described.

A titania paste is applied to one side of a tungsten mesh (current collecting electrode) having a longitudinal length of 50 mm, a lateral length of 120 mm, and a thickness of 36 µm, so as to have a dried film thickness of 15 µm, and is sintered at 500°C for 30 minutes, so that titania (a porous semiconductor layer) is formed. Then, the tungsten mesh with the titania is immersed in 0.05 wt% of a dye solution (black dye, acetonitril made by SOLARONIX Co., Ltd. : t-butyl alcohol = 1:1) for 72 hours.

On the other hand, a counter electrode formed by sputtering platinum onto a titanium foil (having purity of 99.5% or more) having a longitudinal length of 51 mm, a lateral length of 110 mm, and a thickness of 50 µm, and an insulating sheet (insulating layer) having a longitudinal length of 70 mm, a lateral length of 110 mm, and a thickness of 32 µm are prepared.

The current collecting electrode, which is rolled in the state where the surface provided with titania is directed toward the outer side with respect to the counter electrode, is inserted into a glass tube (Spool NW25) which has an inner diameter of 25 mm x a straight tube length of 100 mm and both ends of which has flange structures. Further, the insulating sheet rolled into a tubular shape is slowly inserted into the inner side of the current collecting electrode, and the counter electrode rolled into a tubular shape is inserted into the inner side of the insulating sheet rolled into the tubular shape. In this case, the end section of the insulating sheet is folded into the inner side of the counter electrode. Further, a columnar insulator made of Teflon is inserted into the inner side of the counter electrode. Note that, on the side of the glass tube on which side the current collecting electrode and the insulating layer are disposed, insulating packing is provided so as to prevent that the counter electrode layer and the current collecting electrode are contacted and short-circuited with each other. On the side of the glass tube on which side the current collecting electrode is disposed, a flange type cap (lid body) made of titanium is inserted into the glass tube with packing (Seal outer ring NW25) attached thereto, so that the packing is arranged to be sandwiched between the flange surface of the glass tube and the flange surface of the lid body. A clamp (Clamp chain NW25) is put on the slopes of the lid body and the glass tube in the circumferential direction, so as to plug the lid body and the glass tube. Further, the current collecting electrode is sandwiched between the lid body inserted into the glass tube and a current collecting electrode presser so as to be fixed by a hex screw. On the side on which the counter electrode layer is disposed, similarly to the side on which the current collecting electrode is disposed, a flange type cap (lid body) made of titanium and provided with a check valve (CCRM2550269S manufactured by Lee Co., Ltd.) is inserted into the glass tube, and packing is arranged to be sandwiched between the flange surface of the glass tube and the flange surface of the lid body. A clamp (Clamp chain NW25) is put on the slopes of the lid body and the glass tube in the circumferential direction so as to plug the lid body and the glass tube. At this time, since the counter electrode is provided on the inner wall of the glass tube, the counter electrode is sandwiched in the gap between the inner wall of the glass tube and the lid body inserted into the glass tube, and thereby the counter electrode and the lid body are brought into contact with each other. After injection of an electrolyte made of a γ-butyrolactonesolution containing 40 mM of iodine, 500 mM of LiI, and 580mM of t-Butylpyridine, the cap is closed, so that the dye-sensitized solar cell (battery cell) is manufactured.

The above-described sealing structure 10e of the dye-sensitized solar cell according to the fourth modification, in which the sealing portion of the transparent glass tube is not formed as a thread fixing structure but is formed by flanges, has a simple structure and hence can be manufactured at low cost. Note that the sealing structure 10e of the dye-sensitized solar cell can be similarly applied to the sealing structure 10b of the dye-sensitized solar cell according to the second example of the present embodiment described below.

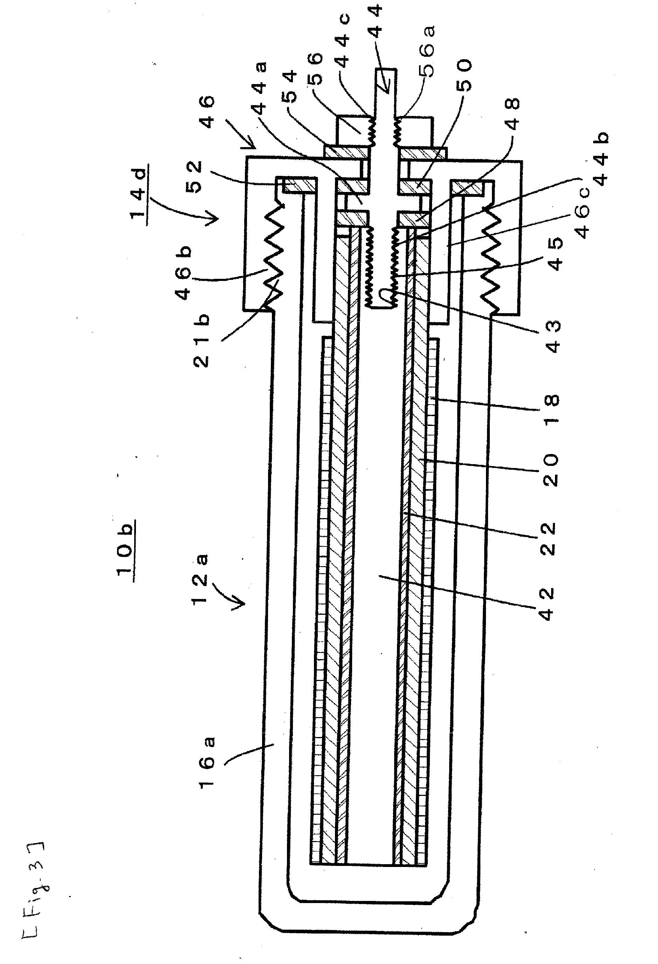

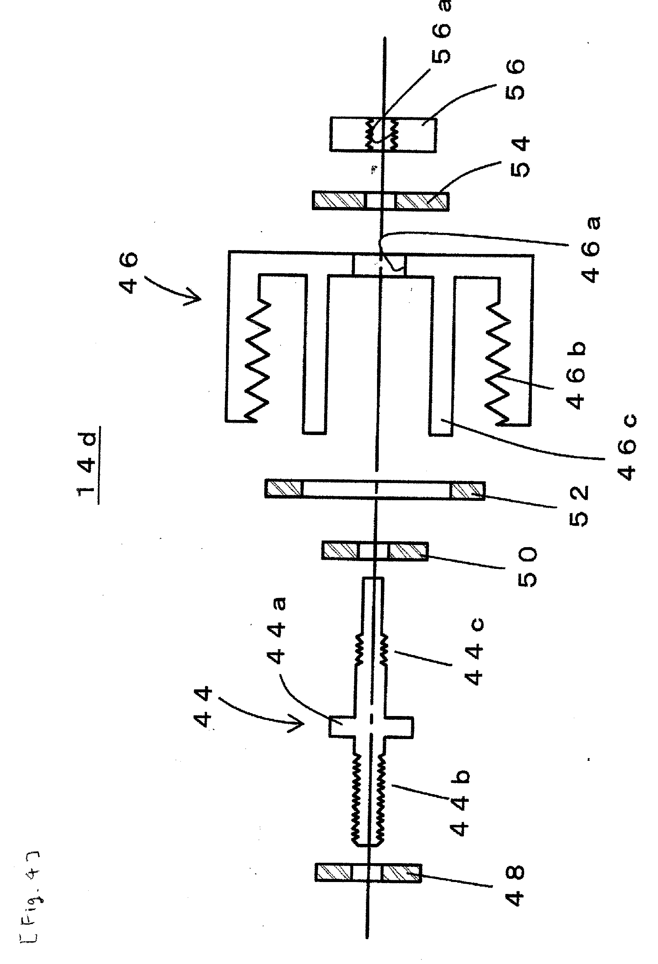

Next, a sealing structure of a dye-sensitized solar cell according to a second example of the present embodiment will be described with reference to a schematic sectional view of a sealing structure of Figure 3 and an exploded sectional view of sealing components (lid body section) of Figure 4.

A sealing structure 10b of the dye-sensitized solar cell according to the second example of the present embodiment shown in Figure 3 and Figure 4 is substantially similar to the sealing structure 10 of the dye-sensitized solar cell according to the first example of the present embodiment, and is configured by a cylindrical dye-sensitized solar cell main body 12a and a sealing section 14d for sealing the open end of the dye-sensitized solar cell main body 12a.

The dye-sensitized solar cell main body 12a is formed in a test tube shape in which one end section of a transparent glass tube 16a is opened and in which the other end section of the transparent glass tube 16a is closed. Note that the transparent glass tube 16a is a straight tube unlike the transparent glass tube 16 with radially expanded and contracted portions. However, such shape differences can be suitably set according to the relationship in shape and dimension between the transparent glass tube and the lid body.

In the dye-sensitized solar cell main body 12a, a counter electrode 42 is formed of a rod-shaped conductive metal material, and a recessed section 43 is provided at one end section of the counter electrode 42. A female screw thread 45 is formed on the recessed section 43. The other cell components except the porous semiconductor layer 18 adsorbing the dye are provided so as to extend to the outer periphery of the recessed section 43 of the counter electrode 42. Except these points, the components of the dye-sensitized solar cell main body 12a are the same as the components of the dye-sensitized solar cell main body 12, and hence the explanation of the components is omitted.

The sealing section 14d is configured by sealing components and one end section of the transparent glass tube 16a, which end section has the male screw thread 21b.

The sealing components are configured by a bolt-like member 44 and a lid body section 46 each of which serves as an extraction electrode, a plurality of pieces of packing 48, 50, 52 and 54 which are sealing members, and a nut 56. Not that a plurality of pieces of insulating packing are used as the plurality of pieces of packing 48, 50 and 54, but a suitable packing material can used for the packing 52.

The bolt-like member 44 is formed of a conductive metal material, and a projecting section 44a having a disk flange shape is provided substantially at the axial direction center of the rod-shaped main body of the bolt-like member 44. Male screw threads 44b and 44c are respectively provided on the outer periphery of both ends of the bolt-like member 44.

The lid body section 46 is a cylindrical member which is made of a conductive metal material and one end section of which is closed. A through hole 46a is formed in the closed bottom surface of the lid body section 46. A cylindrical projecting section 46c is provided on the inner side of the lid body 46. A female screw thread 46b is formed on the inner side of the side surface (circumference wall) of the lid body section 46.

The nut 56 is formed of a suitable metal member, and the like. Reference numeral 56a denotes a screw thread formed on the inner side of the nut 56.

The sealing components are attached to the dye-sensitized solar cell main body 12a by the following procedures.

The side of the screw thread 44b of the bolt-like member 44 is screwed into the recessed section 43 of the counter electrode 42 via the packing 48. Thereby, the bolt-like member 44 is brought into contact with the counter electrode 42, so that the bolt-like member 44 is electrically connected to the counter electrode 42.

Then, the packing 50 is fitted to the bolt-like member 44 so that the packing 50 is brought into contact with the surface of the screw thread 44c of the projecting section 44a of the bolt-like member 44, and also in the state where the packing 52 is arranged on the inner side of the lid body section 46, the lid body section 46 is externally fitted to the transparent glass tube 16a. At this time, the projecting section 46c of the lid body section 46 is brought into sliding contact with the outer periphery of the current collecting electrode 20 so as to cover the counter electrode 42. Thereby, the lid body section 46 is electrically connected to the current collecting electrode 20. Further, the side of the screw thread 44b of the bolt-like member 44 is inserted into the through hole 46a of the lid body section 46. Note that, at this time, a sufficient clearance is provided between the outer periphery of the projecting section 44a of the bolt-like member 44, and the inner periphery of the projecting section 46c of the lid body section 46. However, from a viewpoint of more surely preventing the contact between the outer periphery of the projecting section 44a and the inner periphery of the projecting section 46c of the lid body section 46, it is more preferred, for example, that an insulating spacer is arranged between the outer and inner peripheries, or that the mutually adjacent portions of the outer and inner peripheries are provided with an insulating coating.

Finally, the side of the screw thread 44b of the bolt-like member 44 is screwed with the nut 56 via the packing 54.

Thereby, the open end section of the dye-sensitized solar cell main body 12a is surely sealed. Also, the bolt-like member 44 functions as an extraction electrode of the counter electrode 42, and the lid body section 46 functions as an extraction electrode of the current collecting electrode 20.

Note that, as described above, each of the bolt-like member 44 and the lid body 46 is formed of a conductive metal member, but instead, may also be configured such that the main body or the outer peripheral section of these members is formed of an insulating material, and for example, a conductive metal member axially extending to penetrate these members is provided at the center of these members.

The above-described sealing structure 10b of the dye-sensitized solar cell according to the second example of the present embodiment can provide the same effect as the effect of the sealing structure 10 of the dye-sensitized solar cell according to the first example of the present embodiment. Further, in particular, the one end section of the transparent glass tube 16a is closed, and hence the dye-sensitized solar cell main body can be more surely sealed. Further, the two extraction electrodes are collectively provided on the one end side of the dye-sensitized solar cell main body, and hence this configuration is convenient for arranging the electrode leads.

Further, a dye-sensitized solar cell (photoelectric conversion element) according to the present embodiment has any one of the above-described sealing structures.

Thereby, the above-described effects of the sealing structures can be suitably obtained.

Further, in a dye-sensitized solar cell (photoelectric conversion element) module according to the present embodiment, a plurality of the above-described dye-sensitized solar cells are arranged in series or in parallel with each other via electrode leads connected to the extraction electrodes.

Thereby, the above-described effects of the sealing structures can be suitably obtained.

In the following, examples of the present invention, the solar cell characteristics of which were measured, will be further described. However, the present invention is not limited to these examples.

### (Example 1)

Titanium was sputtered onto both surfaces of a stainless steel mesh (current collecting electrode) having a longitudinal length of 30 mm, a lateral length of 100 mm, and a thickness of 40 µm, so as to have a thickness of 300 nm. Then, a titania paste was applied to one of the sputtered surfaces of the mesh so as to have a dried film thickness of 15 µm, and was sintered at 500°C for 30 minutes, so that titania (a porous semiconductor layer) was formed. Then, the stainless steel mesh with the titania was immersed in 0.05 wt% of a dye solution (black dye, acetonitril made by SOLARONIX Co., Ltd. : t-butyl alcohol = 1:1) for 72 hours.

On the other hand, a counter electrode formed by sputtering platinum onto a titanium foil (having purity of 99.5% or more) having a longitudinal length of 31 mm, a lateral length of 110 mm, and a thickness of 50 µm, and an insulating sheet (insulating layer) having a longitudinal length of 50 mm, a lateral length of 110 mm, and a thickness of 32 µm were prepared.

The current collecting electrode, which was rolled in the state where the surface provided with titania was directed toward the outer side with respect to the counter electrode, was inserted into a glass tube having an inner diameter of 10.4 mm x a straight tube length of 90 and both ends of which are threaded. Further, the insulating sheet rolled into a tubular shape was slowly inserted into the inner side of the current collecting electrode, and the counter electrode rolled into a tubular shape was inserted into the inner side of the insulating sheet rolled into the tubular shape. Note that the current collecting electrode, the insulating sheet, and the counter electrode layer were disposed on one side of the glass tube, and the counter electrode layer was disposed on the other side of the glass tube.

Note that, on the side on which the current collecting electrode and the insulating layer were disposed, insulating packing was provided so as to prevent that the counter electrode layer and the current collecting electrode were contacted and short-circuited with each other. The side of the glass tube on which side the current collecting electrode and the insulating layer were disposed, and the side of the glass tube on which side the counter electrode layer was disposed were each firmly plugged by a threaded cap (lid body) made of titanium. After injection of an electrolyte made of a 3-methoxypropionitrile solution containing 40 mM of iodine, 500 mM of LiI, and 580 mM of t-Butylpyridine, a check valve (CCRM2550269S manufactured by Lee Co., Ltd.) was inserted into the through hole of the lid body in the direction such that gas or electrolyte solution is allowed to flow from the inner side to the outer side of the through hole and is prevented from flowing from the outer side to the inner side of the through hole. The check valve was fixed by hitting the head of the check valve with a wooden hammer. The cap was closed by arranging packing at the portion of the check valve, so that a dye-sensitized solar cell A was manufactured. The manufactured dye-sensitized solar cell A was stored in a room at the temperature of 23 ± 2°C.

The solar cell characteristics were measured by using a solar simulator when pseudo sunlight of AM1.5, 100 mW/cm2 was irradiated onto the manufactured dye-sensitized solar cell A. The conversion efficiency of the dye-sensitized solar cell A was 4.2% after one month of storage. Further, the conversion efficiency of the dye-sensitized solar cell A was 4.0% after five months of storage.

### (Example 2)

A titania paste was applied to one side of a tungsten mesh (current collecting electrode) having a longitudinal length of 30 mm, a lateral length of 100 mm, and a thickness of 36 µm, so as to have a dried film thickness of 15 µm, and was sintered at 500°C for 30 minutes, so that titania (a porous semiconductor layer) was formed. Then, the tungsten mesh with the titania was immersed in 0.05 wt% of a dye solution (black dye, acetonitril made by SOLARONIX Co., Ltd. : t-butyl alcohol = 1:1) for 72 hours.

On the other hand, a counter electrode formed by sputtering platinum onto a titanium foil (having purity of 99.5% or more) having a longitudinal length of 31 mm, a lateral length of 110 mm, and a thickness of 50 µm, and an insulating sheet (insulating layer) having a longitudinal length of 50 mm, a lateral length of 110 mm, and a thickness of 32 µm were prepared.

The current collecting electrode, which was rolled in the state where the surface provided with the titania was directed toward the outer side with respect to the counter electrode, was inserted into a glass tube having an inner diameter of 10.4 mm x a straight tube length of 90 mm and both ends of which are threaded. Further, the insulating sheet rolled into a tubular shape was slowly inserted into the inner side of the current collecting electrode, and the counter electrode rolled into a tubular shape was inserted into the inner side of the insulating sheet rolled into the tubular shape. In this case, the end section of the insulating sheet was folded into the inner side of the counter electrode. Further, a columnar insulator made of Teflon was inserted into the inner side of the counter electrode. Note that the current collecting electrode, the insulating sheet, and the counter electrode layer were disposed on one side of the glass tube, and the counter electrode layer was disposed on the other side of the glass tube.

Note that, on the side on which the current collecting electrode and the insulating layer were disposed, insulating packing was provided so as to prevent that the counter electrode layer and the current collecting electrode were contacted and short-circuited with each other. On the side of the glass tube on which side the current collecting electrode was disposed, the current collecting electrode was sandwiched between the inner lid and the current collecting electrode presser so as to be fixed by a hex-head screw. The side on which the counter electrode layer was disposed was plugged by a threaded cap (lid body) made of titanium. After injection of an electrolyte made of a 3-methoxypropionitrile solution containing 40 mM of iodine, 500 mM of LiI, and 580 mM of t-Butylpyridine, a check valve (CCRM2550269S manufactured by Lee Co., Ltd.) was inserted into the through hole of the lid body in the direction such that gas or electrolyte solution is allowed to flow from the inner side to the outer side of the through hole and is prevented from flowing from the outer side to the inner side of the through hole. The check valve was fixed by hitting the head of the check valve with a wooden hammer. The cap was closed by arranging packing at the portion of the check valve, so that the dye-sensitized solar cell (shown by an arrow B in Figure 7) was manufactured. The manufactured dye-sensitized solar cell was stored in a room at the temperature of 23 ± 2°C.

The solar cell characteristics were measured by using a solar simulator when pseudo sunlight of AM1.5, 100 mW/cm2 was irradiated onto the manufactured dye-sensitized solar cell B. The conversion efficiency of the dye-sensitized solar cell B was 4.4% after one month of storage. Further, the conversion efficiency of the dye-sensitized solar cell B was 4.5% after five months of storage.

### (Example 3)

A titania paste was applied to one side of a tungsten mesh (current collecting electrode) having a longitudinal length of 50 mm, a lateral length of 120 mm, and a thickness of 36 µm so as to have a dried film thickness of 15 µm, and was sintered at 500°C for 30 minutes, so that titania (a porous semiconductor layer) was formed. Then, the tungsten mesh with the titania was immersed in 0.05 wt% of a dye solution (black dye, acetonitril made by SOLARONIX Co., Ltd. : t-butyl alcohol = 1:1) for 72 hours.

On the other hand, a counter electrode formed by sputtering platinum onto a titanium foil (having purity of 99.5% or more) having a longitudinal length of 51 mm, a lateral length of 110 mm, and a thickness of 50 µm, and an insulating sheet (insulating layer) having a longitudinal length of 70 mm, a lateral length of 110 mm, and a thickness of 32 µm were prepared.

The current collecting electrode, which was rolled in the state where the surface provided with titania was directed toward the outer side with respect to the counter electrode, was inserted into a glass tube (Spool NW25) having an inner diameter of 25 mm x a straight tube length of 100 mm and both ends of which has flange structures. Further, the insulating sheet rolled into a tubular shape was slowly inserted into the inner side of the current collecting electrode, and the counter electrode rolled into a tubular shape was inserted into the inner side of the insulating sheet rolled into the tubular shape. In this case, the end section of the insulating sheet was folded into the inner side of the counter electrode. Further, a columnar insulator made of Teflon was inserted into the inner side of the counter electrode. Note that, on the side of the glass tube on which side the current collecting electrode and the insulating layer were disposed, insulating packing was provided so as to prevent that the counter electrode layer and the current collecting electrode were contacted and short-circuited with each other. On the side of the glass tube on which side the current collecting electrode was disposed, a flange type cap (lid body) made of titanium was inserted into the glass tube with packing (Seal outer ring NW25) attached thereto, so that the packing was sandwiched between the flange surface of the glass tube and the flange surface of the lid body. A clamp (Clamp chain NW25) was put on the slopes of the lid body and the glass tube in the circumferential direction, so as to plug the lid body and the glass tube. Further, the current collecting electrode was sandwiched between the lid body inserted into the glass tube and a current collecting electrode presser, so as to be fixed by a hex screw. On the side of the glass tube on which side the counter electrode layer was disposed, similar to the side on which the current collecting electrode was disposed, a flange type cap (lid body) made of titanium was inserted into the glass tube, and packing was arranged to be sandwiched between the flange surface of the glass tube and the flange surface of the lid body. A clamp (Clamp chain NW25) was put on the slopes of the lid body and the glass tube in the circumferential direction, so as to plug the lid body and the glass tube. At this time, since the counter electrode is provided on the inner wall of the glass tube, the counter electrode is sandwiched in the gap between the glass inner wall and the inserted lid body, so that the counter electrode and the lid body are brought into contact with each other. After injection of an electrolyte made of a γ-butyrolactonesolution containing 40 mM of iodine, 500 mM of LiI, and 580 mM of t-Butylpyridine, a check valve (CCRM2550269S manufactured by Lee Co., Ltd.) was inserted into the through hole of the lid body in the direction such that gas or electrolyte solution is allowed to flow from the inner side to the outer side of the through hole and is prevented from flowing from the outer side to the inner side of the through hole. The check valve was fixed by hitting the head of the check valve with a wooden hammer. The cap was closed by arranging packing at the portion of the check valve, so that the dye-sensitized solar cell C was manufactured. The manufactured dye-sensitized solar cell C was stored in a room at the temperature of 23 ± 2°C.

The solar cell characteristics were measured by using a solar simulator when pseudo sunlight of AM1.5, 100 mW/cm2 was irradiated onto the manufactured dye-sensitized solar cell C. The conversion efficiency of the dye-sensitized solar cell C was 3.7% after one month of storage. Further, the conversion efficiency of the dye-sensitized solar cell C was 3.5% after five months of storage.

### Reference Signs List

10, 10a, 10b, 10c, 10d, 10e Sealing structure of dye-sensitized solar cell
12, 12a Dye-sensitized solar cell main body
14a, 14b, 14c, 14d, 14e, 14f, 14g, 14i, 14j Sealing section
16, 16a, 16b, 16c Transparent glass tube
18 Porous semiconductor layer adsorbing dye
20, 20a, 120a Current collecting electrode
21a, 21b, 27a, 27b, 38, 40, 44b, 44c, 45, 46b, 56a, 74e, 76a, 82, 274e, 276a, 85 Screw thread
22, 22a, 122a Insulating layer
24, 24a, 124a Counter electrode layer
26a, 26b, 26c, 26d, 26e, 26g, 26h Lid body
28a, 28b, 30a, 30b, 66, 72b, 72c, 72d, 74b, 74c, 74d, 172b, 172c, 172d, 174d, 174f Protrusion
29a, 29b, 43 Recessed section
32 Insulating packing
34a, 34b, 48, 50, 52, 54, 73, 74a, 78, 80, 173a, 178a, 280 Packing
35 Check valve
42 Counter electrode
44, 81 Bolt-like member
44a Projecting section
46 Lid body section
46c Projecting section
56 Nut
60a, 60b, 60c, 62c, 62d Inner lid section
62a, 62b, 62e Outer lid section
64 Insulator
16e, 16g, 60h, 60j, 66a, 72a, 74a, 172a Flange
68 Coil spring
76, 276 Cap
16d, 16f, 60g, 60i Slope
84, 172e, 274f, 274g Through hole
83 Current collecting electrode presser

## Claims

1. A sealing structure of a photoelectric conversion element wherein
a side surface of a cylindrical or conical transparent member is used as a light receiving surface, and photoelectric conversion cell components are arranged in layers in the transparent member in a radial direction of the transparent member,
a pair of lid bodies are respectively provided at both end sections of the transparent member, and
each of the pair of lid bodies has a conductive metal section extending in an axial direction of the transparent member, one end side of the conductive metal section being electrically connected to one of a pair of electrodes of the photoelectric conversion cell components, so as to be used as an extraction electrode.

2. A sealing structure of a photoelectric conversion element wherein
a side surface of a cylindrical or conical transparent member having a closed one end side is used as a light receiving surface, and photoelectric conversion cell components are arranged in layers in the transparent core member in a radial direction of the transparent member,
a lid body section is provided at an open end section of the transparent member, and
the lid body section includes two mutually insulated conductive metal sections extending to penetrate the lid body section in an axial direction of the transparent member, one end side of one of the conductive metal sections being used as an extraction electrode by being electrically connected to one electrode of the photoelectric conversion cell components, and one end side of the other of the conductive metal sections being used as an extraction electrode by being electrically connected to the other electrode of the photoelectric conversion cell components.

3. The sealing structure of the photoelectric conversion element according to one of claim 1 and claim 2, wherein the photoelectric conversion element is a dye-sensitized solar cell, and the photoelectric conversion cell components include a porous semiconductor layer including a dye, an electrolyte layer, and a pair of electrode layers.

4. The sealing structure of the photoelectric conversion element according to claim 1, wherein
the photoelectric conversion element is a dye-sensitized solar cell, and the photoelectric conversion cell components include a porous semiconductor layer including a dye, an electrolyte layer, and a pair of electrode layers,
a counter electrode layer of the pair of electrode layers is set as the innermost layer and is supported by an insulating material inserted into an inner side of the counter electrode layer, and one end section of an anode electrode of the pair of electrode layers is converged to form a converging section, and
each of the pair of lid bodies has a two body structure configured by an inner lid section and an outer lid section, the inner lid section of one of the pair of lid bodies being brought into sliding contact with the inner side of the counter electrode layer so as to be electrically connected to the counter electrode layer and so as to be exposed from an opening formed in the outer lid section of the one of the pair of lid bodies, the inner lid section of the other of the pair of lid bodies being pressed to the converging section of the anode electrode so as to be electrically connected to the anode electrode and so as to be exposed from an opening formed in the outer lid section of the other of the pair of lid bodies, and an end section of the outermost layer of the photoelectric conversion cell components being closed by the outer lid section of each of the pair of lid bodies.

5. The sealing structure of the photoelectric conversion element according to any one of claims 1 to 4, wherein the lid body has a through hole made to communicate with the electrolyte layer and to penetrate the lid body in the axial direction of the transparent member, and a check valve is attached to the through hole, and the through hole is sealed by a cap.

6. A photoelectric conversion element comprising the sealing structure of the photoelectric conversion element according to any one of claims 1 to 5.

7. A photoelectric conversion element module configured by arranging a plurality of the photoelectric conversion elements according to claim 6 in series or in parallel with each other via electrode leads connected to the extraction electrodes.
